# EUROPEAN PATENT APPLICATION

(11) **EP 0 736 611 A1**
(43) Date of publication of application: **09.10.1996**
(21) Application number: 95890070.6
(22) Date of filing: 04.04.1995
(51) Int. Cl.: C23C 14/24, C23C 14/26

(54) **Heater for evaporation and evaporation equipment**

(71) Applicant: Sony DADC Austria AG, A-5081 Anif (AT)
(72) Inventor: Baumberger, Franz, A-5163 Mattsee (AT); Erhart, Thomas, A-5400 Hallein (AT); Hofer, Günther, A-5090 Lofer (AT); Irnleitner, Norbert, A-5101 Bergheim (AT)
(74) Representative: Kliment, Peter, Dipl.-Ing.

(57) **Abstract**

An equipment for evaporation of aluminum reflecting layers on the surfaces of a plurality of plastic substrates (8) to form optical discs comprises a plurality of ceramic heaters (4) each being formed of boron nitride in a shape of rectangular parallelepiped and having a cavity (4c) on the lowered top surface for placing an aluminum ingot and one or more holes extending from the bottom of the cavity to the bottom surface or one or more side surfaces of the heater. Molten aluminum evaporates from the top surface and also creeps over the side surface as well as inside of the holes to evaporate downwards and to the side, so that an improved overall layer thickness profile is achieved irrespectively of positions of plastic substrates, especially for vertical positioned substrates, in the vacuum evaporation cage.

## Description

The invention relates to a heater for evaporation and an evaporation equipment, and more specifically to a heater used in a process of evaporation of a reflecting layer on optical disc substrates and an evaporation equipment therefor.

In a production process of optical discs like compact disc or video disc, there is a step to evaporate an aluminum reflecting layer on a plastic substrate molded by a nickel stamper. In a disc player, the reflecting layer enables a laser beam from its optical pick-up to be reflected corresponding to the arrangement of pits representing the information recorded on the disc so that the information can be reproduced from the disc.

In order to evaporate an aluminum reflecting layer on the plastic substrate, either vacuum evaporation method or spattering method is employed, and one or more heaters made of tungsten (W) or ceramic boron nitride (BN) are normally used for evaporation of aluminum.

While a tungsten heater makes control of evaporation easier, aluminum and tungsten form an alloy which changes completely the property of the heater and the resistivity of the heater changes quite quickly. Even evaporation process within only 10 evaporation cycles is not as stable as desired. Therefore, it is necessary to change the heaters every 4 or 5 evaporation cycles on an average and maximum every 10 evaporation cycles and this results in increase of manufacturing cost.

On the other hand, a boron nitride heater can be used for more than several hundred and maximum 500 evaporation cycles. Another advantage of boron nitride heaters is its improved process repeatability in comparison with tungsten heaters. However, there are still risks in using boron nitride heaters in production of optical discs.

One of them is degradation of aluminum reflecting layer and decreasing lifetime properties of discs resulting therefrom. Residual stress in the aluminum layer causes so called "hillocks", small crystals, that grow out of the layer and take aluminum from the layer below the hillocks so that holes are created in the aluminum layer. The residual stress increases as the thickness of the aluminum layer is increased. Therefore, it is desirable to achieve as little thickness of the layer as possible with homogeneous aluminum distribution across the disc, while a layer thickness of 480 to 500 Å corresponding to the minimum reflectivity of about 75 % to 90 % (70 % IEC) is required.

Since a boron nitride heater is formed to provide its top surface with a cavity to place an aluminum ingot, aluminum is, however, mainly evaporated upwards and toward the sides of the heater. If plastic substrates are placed to the side wall inside of an evaporation cage, the layer produced on the substrates in lower positions than the heater is thinner than that in higher positions.

In case of multiple heaters provided in an evaporation cage, the sum of individual evaporation from every heater results in a specific overall layer thickness profile from the lowest substrate to the highest substrate. Therefore, even if this profile is aimed to be as flat as possible, the thickness of the layer at the very bottom as well as the very top position is always lower. To achieve the required thickness of the layer in the very bottom and top, much more than the required thickness is obtained in the middle so that risk of aluminum degradation in the discs produced there is increased.

According to the invention, a heater for evaporation comprises a cavity on the top surface to be placed with material to be evaporated and at least one hole extending from the top surface to at least one of the other surfaces. A heater according to the invention has better evaporation characteristics and evaporates not only upwords but also to the side as well as downwards.

According to the invention, an evaporation equipment comprises a power supply, a couple of electrodes connected to said power supply, one or more heaters connected to said couple of electrodes in parallel, supporting member supporting one or more substrates to be evaporated. At least one of the heaters comprises a cavity on the top surface to be placed with material to be evaporated and at least one hole extending from the top surface to at least one of the other surfaces. An evaporation equipment according to the invention shows a better overall thickness profile from the lowest substrate to the highest substrate.

The invention will now be described by way of examples and with reference to the accompanying drawings in which:
Fig. 1 is a schematic diagram showing an example of an evaporation equipment in accordance with the invention.
Figs. 2A and 2B are schematic diagrams showing the first embodiment of a heater in accordance with the invention.
Figs. 3A and 3B are schematic diagrams showing a state of aluminum flow in the first embodiment shown in Figs. 2A and 2B.
Figs. 4A and 4B are schematic diagrams showing the second embodiment of a heater in accordance with the invention.
Figs. 5A and 5B are schematic diagrams showing a state of aluminum flow in the second embodiment shown in Figs. 4A and 4B.

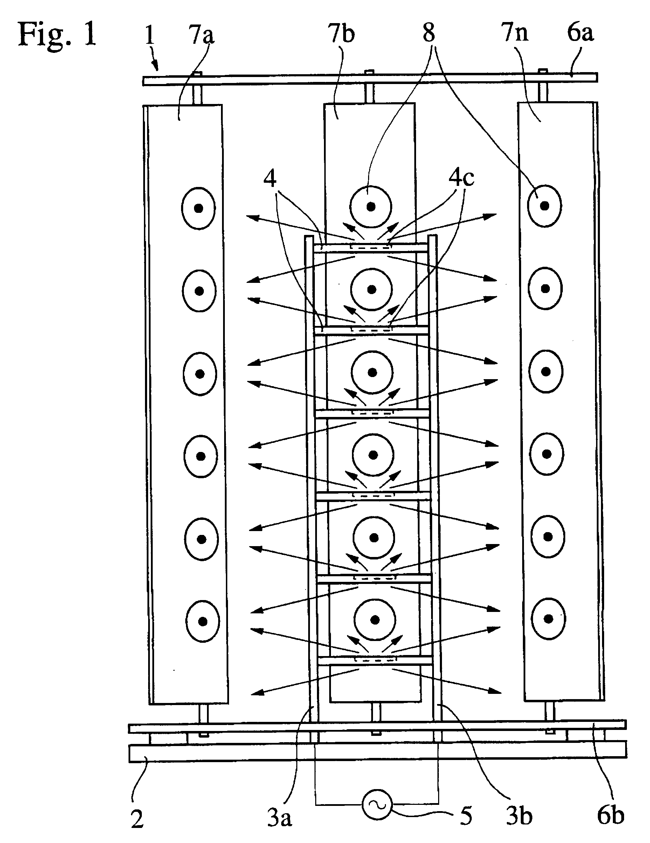

Referring to Fig. 1, an embodiment of the evaporation equipment 1 in accordance with the invention is explained. The evaporation equipment 1 includes a disc-shaped base 2, a couple of electrode poles 3a and 3b made of copper and built up on the center of the base 2, a plurality of heaters 4 bridging the electrode poles 3a and 3b, a power supply 5 connected between the electrode poles 3a and 3b, upper and bottom rings 6a and 6b provided over the base 2, and a plurality of panels 7a, 7b, ..., and 7n each provided between the upper and bottom rings 6a and 6b to revolve round the plurality of heaters 4 along the circumference of the rings 6a and 6b so that the inner side thereof always faces the plurality of heaters 4.

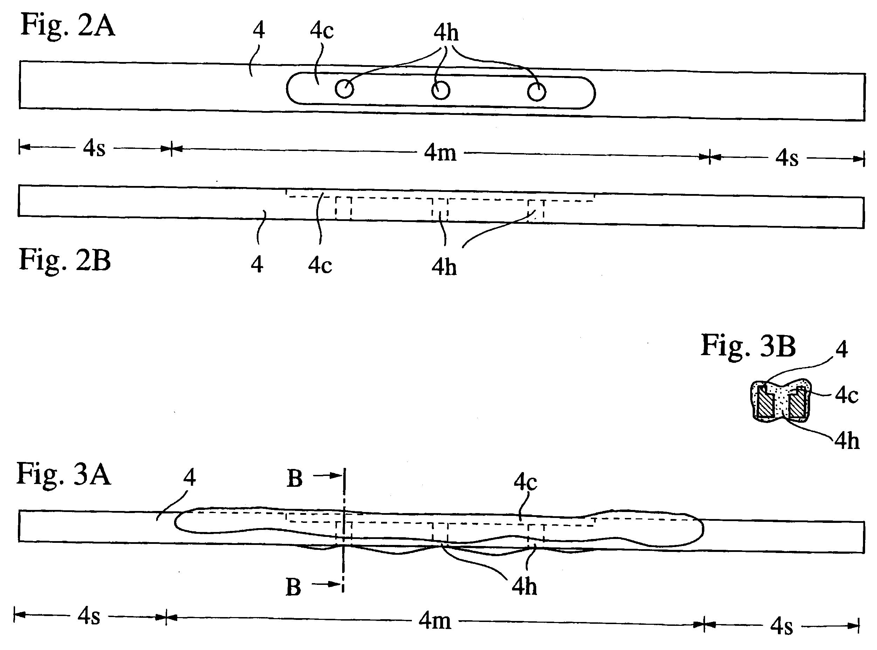

As shown in Figs. 2A and 2B, the heater 4 is formed of ceramic boron nitride into a shape of approximately rectangular parallelepiped (110 mm length, 6 mm width, 4 mm height) having the top surface, bottom surface, two longitudinal side surfaces and two edge surfaces. A cavity 4c (40 mm length, 4 mm width, 1 mm depth) is provided on the top surface of the middle section 4m. The heater 4 is further provided with one or more holes 4h (diameter 2 mm) extending from the bottom of the cavity 4c to the bottom surface or one or more logitudinal side surfaces or edges surfaces thereof. The location of the holes 4h can be optimized. Holes 4c provided more apart from the center of of the heater 4 may improve the evaporation result. The heater 4 is connected to the electrode poles 3a and 3b through a pair of copper cables (not shown) screwed at the both edge parts thereof, respectively.

The positions of the highest and the lowest heaters 4 are first determined so that the required thickness of the layer is satisfied. Then the positions of the other heaters 4 are optimised so that the overall layer thickness profile becomes as flat as possible with the best uniformity. This can be achieved without change of the remaining part of evaporation equipment.

Several plastic substrates 8 to be evaporated with aluminum reflecting layer are attached on the inner side of each panel 7a, 7b, ..., and 7n and aluminum ingots (not shown) are placed in the cavity 4c of each heater 4. After the evaporation equipment 1 is placed inside of a vacuum cage (not shown) and the air within the cage is exhausted, the power supply 5 is switched on. The aluminum ingot on the cavity 4c is heated by the heater 4 and molten to be finally evaporated on the plastic subtrates on the panels 7a, 7b, ..., and 7n.

The aluminum flow and aluminum wetting have a very high impact on evaporation characteristics. As the geometry of the heater 4 determines its wetting, it also influences the evaporation characteristics. The evaporation direction is perpendicular to the wetted surface. Vertical surfaces covered with aluminum will evaporate to the side and the horizontal surfaces will mainly evaporate up or down.

The aluminum evaporation process can be divided into several phases. In the first phase the heater 4 and the aluminum ingot is warmed up until the aluminum ingot reaches its melting point.

After complete melting of the aluminum ingot, the surface tension of the now liquid aluminum is very high and a small aluminum ball is formed in the cavity 4c of the heater 4. Of course, in a vacuum the aluminum starts to evaporate as soon as it is molten but the evaporation rate is rather low at this stage.

Introduction of more current through the heater 4 will lead to increase temperature of the aluminum and this increased temperature lowers the aluminum surface tension significantly. First the aluminum ball forms a small lake in the cavity 4c. Then the aluminum creeps out of the cavity 4c and wets the heater 4 depending on its geometry as shown in Figs. 3A and 3B. In this embodiment, aluminum which overflowed the cavity 4c covers the top surface and also both logitudinal side surfaces. Simultaneously aluminum creeps from the bottom of the cavity 4c through the inner surface of each hole 4h to the bottom surface and the side surfaces of the heater 4.

Aluminum flow will finally cover all surfaces surrounding the cavity 4c more or less irrespective of whether it has to creep up or down. The surface tension of the aluminum is now so low that the adhesive force to any surface overcomes gravity.

In the last phase the aluminum evaporates from the wetted surfaces and the heater finally gets completely rid of the aluminum. This is very important to achieve reproducible results also for the next evaporation cycle. Remaining aluminum from the last evaporation would lead to uncontrolled accumulation of aluminum in the heater in case of multiple evaporation.

Apart from the above embodiment, different forms of the cavity 4c can be obtained by grinding instead of milling to provide smooth edges at the bottom of the cavity 4c. The corner of the bottom of the cavity 4c and the inner surface of each hole 4h as well as the corner of the bottom or longitudinal side surface of the heater 4 and the inner surface of each hole 4h can be rounded to enable aluminum flow to easily creep through.

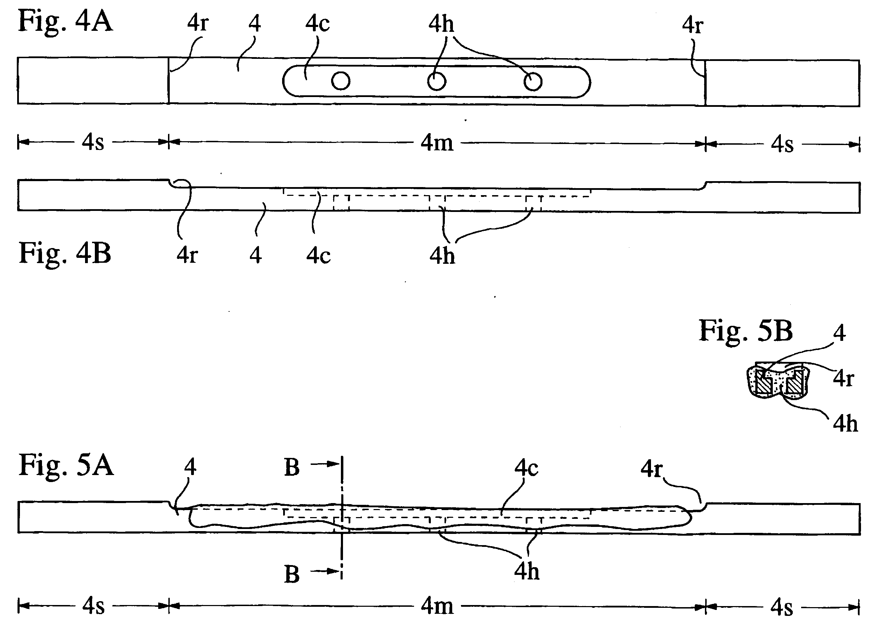

Instead of the flat top surface as explained above, the heater 4 may be formed to have a slightly lowered surface in the middle section 4m continuing from the top surface in the respective side sections 4s through the respective ramp section 4r, on which a cavity 4c is provided, as shown in Figs. 4A and 4B. As the ramps 4r are provided on the top surface, the aluminum flow remains within the middle section 4m as shown in Figs. 5A and 5B.

## Claims

1. A heater for evaporation comprising a cavity (4c) on the top surface to be placed with material to be evaporated and at least one hole (4h) extending from the top surface to at least one of the other surfaces.

2. A heater as claimed in Claim 1, characterized in that said hole extends from the bottom of the cavity to the bottom surface.

3. A heater as claimed in Claim 1, characterized in that said hole extends from the bottom of the cavity to the logitudinal side surface.

4. A heater as claimed in Claim 1, characterized in that said top surface is lowered at the middle section thereof.

5. A heater as claimed in Claim 1, characterized in that the material composing the heater is ceramic.

6. A heater as claimed in Claim 5, characterized in that ceramic is boron nitride.

7. An evaporation equipment comprising a power supply, a couple of electrodes connected to said power supply, one or more heaters connected to said couple of electrodes in parallel, and means for supporting one or more substrates to be evaporated, each of said one or more heaters comprising a cavity (4c) on the top surface to be placed with material to be evaporated and, characterised in that one of said one or more heaters comprises a at least one hole (4h) extending from the top surface to at least one of the other surfaces.
